# EUROPEAN PATENT SPECIFICATION

(11) **EP 3 062 391 B1**
(45) Date of publication and mention of the grant of the patent: **19.06.2019**
(21) Application number: 14795103.2
(22) Date of filing: 15.04.2014
(51) Int. Cl.: H05K 1/02, H01Q 1/52

(54) **PCB BOARD, TERMINAL AND METHOD FOR IMPROVING ANTI-INTERFERENCE CAPABILITY OF PCB BOARD**
LEITERPLATTE, ENDGERÄT UND VERFAHREN ZUR VERBESSERUNG DER ENTSTÖRUNGSFÄHIGKEIT EINER LEITERPLATTE
CARTE DE CIRCUITS IMPRIMÉS, TERMINAL ET PROCÉDÉ D'AMÉLIORATION DE LA CAPACITÉ ANTI-INTERFÉRENCE D'UNE CARTE DE CIRCUITS IMPRIMÉS

(30) Priority: 23.10.2013 CN 201310505234
(43) Date of publication of application: 31.08.2016
(73) Proprietor: ZTE Corporation, Shenzhen, Guangdong 518057 (CN)
(72) Inventor: LUO, Ling, Shenzhen Guangdong 518057 (CN); CHENG, Pangang, Shenzhen Guangdong 518057 (CN); LUO, Yibao, Shenzhen Guangdong 518057 (CN)
(74) Representative: Potter Clarkson
(86) International application number: PCT/CN2014/075348
(87) International publication number: WO 2014/180223

(56) References cited:
- WO-A2-2012/059302
- CN-A- 102 595 296
- CN-Y- 2 749 066
- CN-Y- 201 430 744
- US-A1- 2007 159 401
- US-A1- 2012 194 391
- US-A1- 2013 017 786
- US-B1- 6 421 016

## Description

### TECHNICAL FIELD

The present disclosure generally relates to the field of PCB design, especially to a PCB board, a terminal and a method for improving an anti-interference capability of the PCB board.

### BACKGROUND

At present, PCB boards are more and more widely used. Since functional application chips on the PCB become more and more, various base-band radio frequency (RF) chips are integrated into a same PCB mainboard, which causes a prominent electromagnetic perturbation problem on the PCB mainboard. Interference signals having different frequency spectrums are generally measured at a common ground terminal of the PCB board. Such interference signals radiate out by using the mainboard ground as an antenna, and some frequencies fall into a frequency band of a working antenna, which brings out a great interference to signals of the working antenna. This is the reason why a power sensitivity of cable test is normal in items, but the index by the coupling OTA test is poor. During the development of the PCB board of the terminal, in many terminal items, the interference signals may be measured at the common ground terminal of the mainboard, and some of these interference signals are within the RF working frequency band, such interference signals radiate out via ground, which reflects the coupling performance of the terminal, and the radiating area is near to the location of the antenna, once the radiated in-band signals are relatively strong, they would affect the wireless performance of the terminal. The RF debugging means can only slightly solve this problem, such fault is a recurrent fault of the current smart terminal, and when the fault is serious, the success of the item may be even affected. The interference to the working antenna of the PCB brings out many troubles to the terminal items, and it is very difficult to deal with it.

WO 2012/059302 discloses an antenna device in which a first antenna element is a rod-shaped antenna element provided elevated from a supporting structure. A transmission line connects the first antenna element to a central processing unit. The supporting structure is a printed circuit board and the transmission line connects the first antenna element to the central processing unit. A parasitic antenna element is provided opposite the first antenna element. A conducting element is provided interconnecting the first antenna element and the parasitic antenna element.

CN 102595296 A discloses a hearing aid compatible device comprising a circuit board, which comprises a main antenna and a secondary antenna connected to the ground of the circuit board. In order to effectively reduce interference, the length of the secondary antenna is greater than or less than a quarter of the wavelength of a desired reduced frequency band.

CN 201 430 744 Y discloses an apparatus for canceling electromagnetic interference, including an interference signal receiving antenna and a grounding member, and the interference signal receiving antenna is connected to a ground line of an electronic operating system for eliminating electromagnetic interference through the grounding member.

### SUMMARY

The invention is defined by the claims. From above, the system of the embodiments of the present disclosure provides a PCB board, a terminal and a method for improving an anti-interference capability of the PCB board, which solve the interference problem to the working antenna by the interference signals on the common ground terminal of the PCB board.

The embodiments of the present disclosure provide a PCB board as defined in claim 1 including a working antenna and an anti-interference antenna, wherein impedance between a signal input terminal of the working antenna and a common ground terminal of the PCB board is greater than impedance between a signal input terminal of the anti-interference antenna and the common ground terminal of the PCB board.

In an embodiment of the present disclosure, the working antenna is a monopole antenna.

In an embodiment of the present disclosure, the signal input terminal of the anti-interference antenna is connected to the common ground terminal.

In an embodiment of the present disclosure, a resonant frequency of the anti-interference antenna falls into a receiving frequency band of the working antenna.

According to the invention, the anti-interference antenna is provided with a resonant frequency control circuit.

In an embodiment of the present disclosure, polarization orientations of the working antenna and the anti-interference antenna are perpendicular to one another.

In an embodiment of the present disclosure, the working antenna and the anti-interference antenna are located at edges on different sides of the PCB board.

The present disclosure also provides a mobile terminal of an anti-interference PCB board, wherein the mobile terminal includes the above-mentioned PCB board.

The present disclosure also provides a method for enhancing an anti-interference capability of a PCB board as defined in claim 8.

In an embodiment of the present disclosure, a monopole antenna is set as the working antenna.

In an embodiment of the present disclosure, the signal input terminal of the anti-interference antenna is set to be connected to the common ground terminal.

The advantageous effects of the embodiments of the present disclosure are as follows.

In the PCB board, the terminal and the method for improving an anti-interference capability of the PCB board provided by the embodiments of the present disclosure, by providing an anti-interference antenna on the PCB board and setting impedance between a signal input terminal of the working antenna and a common ground terminal of the PCB board to be greater than impedance between a signal input terminal of the anti-interference antenna and the common ground terminal of the PCB board, according to the impedance matching principle, the interference signals would be guided to the signal input terminal of the anti-interference antenna. Further, the radiated interference to the working antenna by the anti-interference antenna may be reduced by making the anti-interference antenna be away from the working antenna, and making the polarization orientations of the working antenna and the anti-interference antenna be perpendicular to one another to have different polarizations. Further, the anti-interference antenna is provided with the resonant frequency control circuit, thereby the resonant frequency of the anti-interference antenna may be fine-tuned. In this way, it is ensured that the signals entered into the working antenna are relatively pure, thereby power conversion may be carried out by utilizing the antenna to the most extent, and the anti-interference capability of the working antenna is improved.

### BRIEF DESCRIPTION OF THE DRAWINGS

Fig. 1 is a schematic diagram of principle of an anti-interference PCB board according to embodiments of the present disclosure;
Fig. 2 is a structural schematic diagram of a mode of setting the anti-interference antenna according to an embodiment of the present disclosure;
Fig. 3 is a structural schematic diagram of a mode of setting the anti-interference antenna according to another embodiment of the present disclosure;
Fig. 4 is a structural schematic diagram of a mode of setting the anti-interference antenna according to another embodiment of the present disclosure; and
Fig. 5 is a flow chart of a method for enhancing an anti-interference capability of a PCB board according to an embodiment of the present disclosure.

### DETAILED DESCRIPTION

Hereinafter, further detailed description of the present disclosure would be given by the specific embodiments in combination with the drawings.

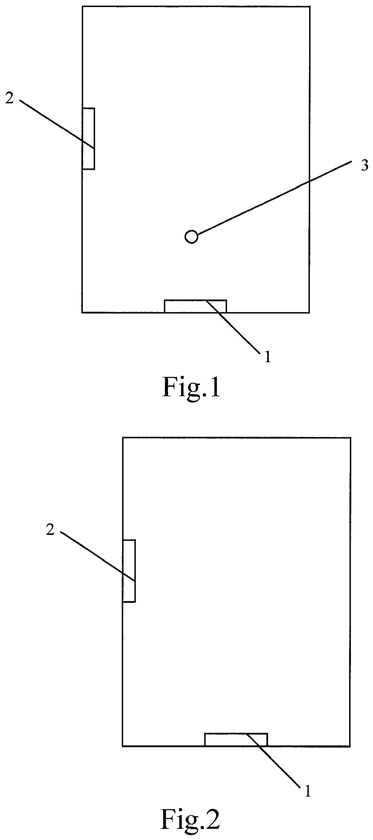

As shown in Fig. 1, the embodiments of the present disclosure provides an anti-interference PCB board including a working antenna, the anti-interference PCB board is further provided with an anti-interference antenna, and impedance between a signal input terminal of the working antenna and a common ground terminal of the PCB board is greater than impedance between a signal input terminal of the anti-interference antenna and the common ground terminal of the PCB board, wherein the anti-interference antenna is provided with a resonant frequency control circuit.

In the present embodiment, a common ground terminal 2 of a mainboard is proposed to be used as a radiating antenna of interference signals. Various interference signals are generated at the common ground terminal 2 of the mainboard due to the operations of various components on the mainboard, all the interference signals with different frequencies would flow to the common ground terminal 2, and the common ground terminal 2 would radiate a large amount of interference signals. When the working antenna 1 is relatively near to the common ground terminal 2, the radiated interference signals (especially the interference signals with the frequency falling within a working frequency band of the working antenna, and especially when the signals are relatively strong) generated at the common ground terminal 2 would enter into the working antenna 1 via the signal input terminal of the working antenna 1 to disturb the working antenna. By providing an anti-interference antenna 3 on the PCB board, and making impedance existing between a signal input terminal of the working antenna 1 and the common ground terminal 2 be greater than impedance between the signal input terminal of the anti-interference antenna 3 and the common ground terminal 2, according to the impedance matching principle, the interference signals existing at the common ground terminal 2 would be guided to the anti-interference antenna 3, rather than flowing to the working antenna 1 from the common ground terminal 2. In this way, the interference signals enter into the anti-interference antenna 3, thereby reducing the interference from the interference signals to the working antenna 1.

Further, in order to make the impedance between the signal input terminal of the working antenna 1 and the common ground terminal be as large as possible, the ground of the working antenna and the signal input terminal of the working antenna are not conducted (that is, there is a relatively large impedance between the signal input terminal of the working antenna and the common ground terminal, thereby the interference signals at the common ground terminal of the mainboard would not flow to the working antenna from the common ground terminal). In this way, the interference signals at the common ground terminal may flow to the anti-interference antenna better, thereby reducing the impact on the working antenna. For example, when the working antenna is a monopole antenna, since the monopole antenna has no ground pin, i.e., the working antenna is not conducted with the common ground terminal, the impedance of the working antenna is relatively large. Other antennas not conducted with the common ground terminal may obtain a relatively large impedance, and thus the interference signals at the common ground terminal flow to the anti-interference antenna.

Further, in order to make the impedance between the signal input terminal of the anti-interference antenna 1 and the common ground terminal be as small as possible, in the embodiments of the present disclosure, the impedance between the signal input terminal of the working antenna and the common ground terminal of the PCB board is made be greater than the impedance between the signal input terminal of the anti-interference antenna and the common ground terminal of the PCB board, then the interference signals may be led to the anti-interference antenna. Thereby, when satisfying the above condition, since the interference signals at the common ground terminal of the mainboard would flow to the anti-interference antenna connected with the ground of the mainboard, the anti-interference antenna is equivalent to a resonant frequency load of the common ground terminal of the mainboard. And the interference signals on the common ground terminal of the mainboard are leaked out via the anti-interference antenna, thereby a proper load resistor may be added at a matching terminal of the anti-interference antenna for consuming the energy of the interference signals and reducing the radiating strength of the interference signals on the premise that the flowing direction of the interference signals is ensured. Especially, it is possible to make the ground of the working antenna be connected and conducted with the signal input terminal of the working antenna (that is, there is a relatively small impedance between the signal input terminal of the anti-interference antenna and the common ground terminal, thereby the interference signals at the common ground terminal of the mainboard would flow to the anti-interference antenna from the common ground terminal), thus the interference signals at the common ground terminal may be properly enabled to flow to the anti-interference antenna, so as to reduce the impact on the working antenna.

Further, since the main interference to the working antenna is the interference signal having a frequency falling within a working frequency band of the working antenna, by leading the interference signals having the frequencies falling within the working frequency band of the working antenna to the anti-interference antenna as much as possible to radiate out the interference signals, and making the resonance frequency of the anti-interference signal falling into the frequency band of the working antenna, the interference signals whose frequencies fall within the frequency band of the working antenna at the common ground terminal can be guided to the anti-interference antenna as far as possible, and such interference signals having relatively great influence to the working antenna may be radiated out as much as possible via the anti-interference antenna, thereby reducing the impact on the working antenna. In order to better control the resonant frequency of the anti-interference antenna, a resonant frequency control circuit is provided at the anti-interference antenna, thereby the resonant frequency of the anti-interference antenna may be fine-tuned, and the interference signals greatly affecting the working antenna enter into the anti-interference antenna to be radiated out better. For example, a π-type matching circuit is provided at the anti-interference antenna, thereby the resonant frequency and the impedance of the anti-interference antenna may be fine-tuned. Also, other different types of circuits may be provided for adjusting the resonant frequency of the antenna.

Further, since the interference signals are radiated out via the anti-interference antenna, the radiated out interference signals may also enter into the signal input terminal of the working antenna. In order to better avoid the interference to the working antenna by the interference signals, by utilizing the effect of different polarizations, an isolation between the interference signals and the working antenna may be improved, and the anti-interference capability of the working antenna is improved. For example, the polarization orientation of the working antenna is a horizontal polarization, and the polarization orientation of the anti-interference antenna is a vertical polarization, then the polarization orientations of them are mutually perpendicular, and a space isolation therebetween is relatively large, thereby the radiation influence occurred therebetween is relatively small. Similarly, when the polarization orientation of the working antenna is the vertical polarization, the polarization orientation of the anti-interference antenna may be set to be the horizontal polarization. Other manners of setting the polarization orientations of the working antenna and the anti-interference antenna to be different may also increase separation between the interference signals and the main antenna, and improve the anti-interference capability of the main antenna.

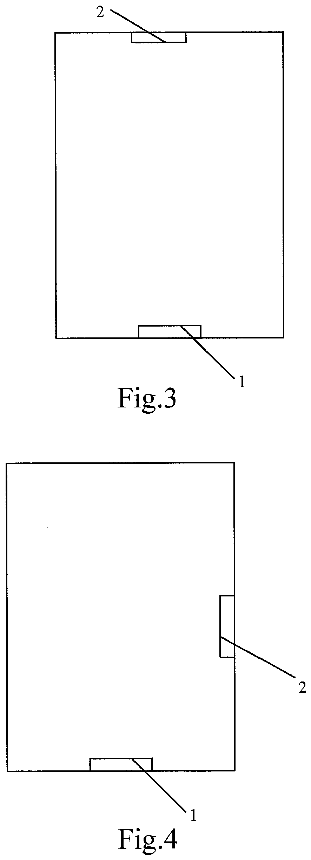

Further, the anti-interference antenna is made be far from the working antenna, and the anti-interference antenna and the working antenna are located at edges on different sides of the PCB board, for example, the anti-interference antennal is located at an adjacent side or an opposite side of the working antenna. In the present embodiment, a rectangle PCB board is used as an example for detailed explanations. As shown in Fig. 2, the working antenna is provided at a lower side of the PCB board, and the anti-interference antenna is provided at a left side of the PCB board. As shown in Fig. 3, the working antenna is provided at the lower side of the PCB board, and the anti-interference antenna is provided at an upper side of the PCB board. As shown in Fig. 4, the working antenna is provided at the lower side of the PCB board, and the anti-interference antenna is provided at a right side of the PCB board. There may be other settings, as long as the working antenna is away from the anti-interference antenna to reduce the radiation influence to the working antenna by the anti-interference antenna.

The embodiments of the present disclosure also provide a terminal including the above-mentioned PCB board. For example, the working antenna is an antenna for a 2G network, an antenna for a 3G network, an antenna for a WIFI network, an antenna for Bluetooth, or an antenna for GPS network. In various mobile terminals, such as a mobile TV, a vehicle-mounted device, a tablet computer and the like, especially in a phone terminal, the working antenna of the phone terminal is provided at a bottom of the phone, and generally components, such as mic, speaker and the like, are laid at the bottom of the phone, such components in the original antenna design would couple the signals including other various high speed signals into the working antenna, and such signals may enter into the working antenna via the signal input terminal of the working antenna to interfere the operation of the working antenna. After setting the anti-interference antenna, since the impedance between the signal input terminal of the anti-interference antenna and the common ground terminal is less than the impedance between the working antenna and the common ground terminal, such interference signals would be diverted to the anti-interference antenna to ensure that the signals entering into the working antenna is relatively pure, such that the power conversion may be carried out by utilizing the antenna to the maximum extent.

The embodiments of the present disclosure also provide a method for enhancing an anti-interference capability of a PCB as defined in claim 8, wherein a working antenna and an anti-interference antenna are provided on the PCB board, and impedance between a signal input terminal of the working antenna and a common ground terminal of the PCB board is set to be greater than impedance between a signal input terminal of the anti-interference antenna and the common ground terminal of the PCB board.

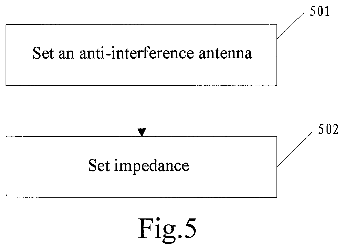

With reference to Fig. 5, the method for enhancing an anti-interference capability of a PCB board provided by the present embodiment includes the following steps.

In step 501, an anti-interference antenna is provided on the PCB board.

In step 502, impedance is set.

In the above step 501, the anti-interference antenna on the PCB board may specifically be provided by: designing an anti-interference antenna, the type of the anti-interference antenna being determined according to particular requirements, and then installing the anti-interference antenna on the PCB board. It should be noted that the position of the antenna may be determined according to specific actual conditions, including a resonant frequency of the antenna, impedance circuit of the antenna, a polarization orientation of the antenna, a load of the antenna, and the like.

In the above step 502, the impedance may specifically be set by: setting impedance between a signal input terminal of the working antenna and a common ground terminal of the PCB board to be greater than impedance between a signal input terminal of the anti-interference antenna and the common ground terminal of the PCB board.

When the above conditions are satisfied, it is preferable to make the impedance between the working antenna and the common ground terminal be as large as possible, that is, to make the working antenna and the common ground terminal not conducted. For example, a monopole antenna is set as the working antenna, and other antennas which are not conducted with the common ground terminal may also be used as the working antenna.

Similarly, it is possible to make the impedance between the anti-interference antenna and the common ground terminal be as small as possible, that is, to make the anti-interference antenna and the common ground terminal be connected and conducted, then it can be ensured that the impedance between the anti-interference antenna and the common ground terminal besides the load and the impedance of the circuit per se is minimum. As long as the above condition that the impedance between the signal input terminal of the working antenna and the common ground terminal of the PCB board is greater than the impedance between the signal input terminal of the anti-interference antenna and the common ground terminal of the PCB board is satisfied, any other settings are feasible.

The embodiments of the present disclosure improve the anti-interference capability of the working antenna on the PCB board, make the interference signals on the PCB board to be radiated out via the anti-interference antenna, reduce the radiation influence to the working antenna by the interference signals, and improve the anti-interference capability of the working antenna.

The above-mentioned contents are only preferable embodiments of the present disclosure, which do not tend to limit the protection scope defined by the appended claims.

### Industry Applicability

In the PCB board, the terminal and the method for improving an anti-interference capability of the PCB board provided by the embodiments of the present disclosure, by providing an anti-interference antenna on the PCB board and setting impedance between a signal input terminal of the working antenna and a common ground terminal of the PCB board to be greater than impedance between a signal input terminal of the anti-interference antenna and the common ground terminal of the PCB board, according to the impedance matching principle, the interference signals would be guided to the signal input terminal of the anti-interference antenna. Further, the radiated interference to the working antenna by the anti-interference antenna may be reduced by making the anti-interference antenna be away from the working antenna, and making the polarization orientations of the working antenna and the anti-interference antenna be perpendicular to one another to have different polarizations. Further, the anti-interference antenna is provided with the resonant frequency control circuit, thereby the resonant frequency of the anti-interference antenna may be fine-tuned. In this way, it is ensured that the signals entered into the working antenna are relatively pure, thereby power conversion may be carried out by utilizing the antenna to the most extent, and the anti-interference capability of the working antenna is improved.

## Claims

1. A PCB board, **characterized in that**, the PCB board comprises a working antenna (1) and an anti-interference antenna (3), and impedance between a signal input terminal of the working antenna (1) and a common ground terminal (2) of the PCB board is greater than impedance between a signal input terminal of the anti-interference antenna (3) and the common ground terminal (2) of the PCB board,
wherein the anti-interference antenna (3) is provided with a resonant frequency control circuit configured such that an interference signal at the common ground terminal (2) enters into the anti-interference antenna (3) to be radiated out.

2. The PCB board of claim 1, wherein the working antenna (1) is a monopole antenna.

3. The PCB board of claim 1, wherein the signal input terminal of the anti-interference antenna (3) is connected to the common ground terminal (2).

4. The PCB board of any one of claims 1-3, wherein a resonant frequency of the anti-interference antenna (3) falls into a receiving frequency band of the working antenna (1).

5. The PCB board of any one of claims 1-3, wherein polarization orientations of the working antenna (1) and the anti-interference antenna (3) are perpendicular to one another.

6. The PCB board of any one of claims 1-3, wherein the working antenna (1) and the anti-interference antenna (3) are located at edges on different sides of the PCB board.

7. A terminal, **characterized in that**, the terminal comprises the PCB board of any one of claims 1-6.

8. A method for enhancing an anti-interference capability of a PCB board which has a working antenna (1), **characterized in that** the method comprises:
providing (501) an anti-interference antenna (3) on the PCB board; and
setting (502) impedance between a signal input terminal of the working antenna (1) and a common ground terminal (2) of the PCB board to be greater than impedance between a signal input terminal of the anti-interference antenna (3) and the common ground terminal (2) of the PCB board,
wherein the anti-interference antenna (3) is provided with a resonant frequency control circuit configured such that an interference signal at the common ground terminal (2) enters into the anti-interference antenna (3) to be radiated out.

9. The method of claim 8, further comprising: setting a monopole antenna as the working antenna (1).

10. The method of claim 8, further comprising: setting the signal input terminal of the anti-interference antenna (3) to be connected to the common ground terminal (2).

## Patentansprüche

1. Leiterplatte, **dadurch gekennzeichnet, dass** die Leiterplatte eine Arbeitsantenne (1) und eine Anti-Interferenz-Antenne (3) umfasst, und wobei eine Impedanz zwischen einem Signaleingangsanschluss der Arbeitsantenne (1) und einem gemeinsamen Erdungsanschluss (2) der Leiterplatte größer als eine Impedanz zwischen einem Signaleingangsanschluss der Anti-Interferenz-Antenne (3) und dem gemeinsamen Erdungsanschluss (2) der Leiterplatte ist,
wobei die Anti-Interferenz-Antenne (3) mit einer Resonanzfrequenzsteuerschaltung vorgesehen ist, die derart konfiguriert ist, dass ein Interferenzsignal am gemeinsamen Erdungsanschluss (2) in die Anti-Interferenz-Antenne (3) eintritt, um abgestrahlt zu werden.

2. Leiterplatte nach Anspruch 1, wobei die Arbeitsantenne (1) eine Monopolantenne ist.

3. Leiterplatte nach Anspruch 1, wobei der Signaleingangsanschluss der Anti-Interferenz-Antenne (3) mit dem gemeinsamen Erdungsanschluss (2) verbunden ist.

4. Leiterplatte nach einem der Ansprüche 1 bis 3, wobei eine Resonanzfrequenz der Anti-Interferenz-Antenne (3) in ein Empfangsfrequenzband der Arbeitsantenne (1) fällt.

5. Leiterplatte nach einem der Ansprüche 1 bis 3, wobei die Polarisationsrichtungen der Arbeitsantenne (1) und der Anti-Interferenz-Antenne (3) senkrecht zueinander sind.

6. Leiterplatte nach einem der Ansprüche 1 bis 3, wobei sich die Arbeitsantenne (1) und die Anti-Interferenz-Antenne (3) an den Rändern verschiedener Seiten der Leiterplatte befinden.

7. Anschluss, **dadurch gekennzeichnet, dass** der Anschluss die Leiterplatte nach einem der Ansprüche 1 bis 6 umfasst.

8. Verfahren zum Verbessern der Anti-Interferenz-Fähigkeit einer Leiterplatte, die eine Arbeitsantenne (1) aufweist, **dadurch gekennzeichnet, dass** das Verfahren Folgendes umfasst:
Bereitstellen (501) einer Anti-Interferenz-Antenne (3) auf der Leiterplatte; und
Einstellen (502) einer Impedanz zwischen einem Signaleingangsanschluss der Arbeitsantenne (1) und einem gemeinsamen Erdungsanschluss (2) der Leiterplatte, die größer als eine Impedanz zwischen einem Signaleingangsanschluss der Anti-Interferenz-Antenne (3) und dem gemeinsamen Erdungsanschluss (2) der Leiterplatte ist,
wobei die Anti-Interferenz-Antenne (3) mit einer Resonanzfrequenzsteuerschaltung vorgesehen ist, die derart konfiguriert ist, dass ein Interferenzsignal am gemeinsamen Erdungsanschluss (2) in die Anti-Interferenz-Antenne (3) eintritt, um abgestrahlt zu werden.

9. Verfahren nach Anspruch 8, ferner umfassend:
Einstellen einer Monopolantenne als Arbeitsantenne (1).

10. Verfahren nach Anspruch 8, ferner umfassend:
Einstellen des Signaleingangsanschlusses der Anti-Interferenz-Antenne (3), um mit dem gemeinsamen Erdungsanschluss (2) verbunden zu werden.

## Revendications

1. Carte de circuit imprimé, **caractérisée en ce que** la carte de circuit imprimé comprend une antenne de travail (1) et une antenne anti-interférence (3), et l'impédance entre une borne d'entrée de signal de l'antenne de travail (1) et une borne de masse commune (2) de la carte de circuit imprimé est supérieure à l'impédance entre une borne d'entrée de signal de l'antenne anti-interférence (3) et la borne de masse commune (2) de la carte de circuit imprimé, l'antenne anti-interférence (3) étant munie d'un circuit de commande de la fréquence de résonance configuré de telle sorte qu'un signal d'interférence au niveau de la borne de masse commune (2) entre dans l'antenne anti-interférence (3) pour être diffusé.

2. Carte de circuit imprimé selon la revendication 1, dans laquelle l'antenne de travail (1) est une antenne unipolaire.

3. Carte de circuit imprimé selon la revendication 1, dans laquelle la borne d'entrée de signal de l'antenne anti-interférence (3) est connectée à la borne de masse commune (2).

4. Carte de circuit imprimé selon l'une quelconque des revendications 1 à 3, dans laquelle une fréquence de résonance de l'antenne anti-interférence (3) tombe dans une bande de fréquence de réception de l'antenne de travail (1).

5. Carte de circuit imprimé selon l'une quelconque des revendications 1 à 3, dans laquelle les orientations de polarisation de l'antenne de travail (1) et de l'antenne anti-interférence (3) sont perpendiculaires l'une par rapport à l'autre.

6. Carte de circuit imprimé selon l'une quelconque des revendications 1 à 3, dans laquelle l'antenne de travail (1) et l'antenne anti-interférence (3) sont situées sur les bords de différentes faces de la carte de circuit imprimé.

7. Borne, **caractérisée en ce qu'**elle comprend la carte de circuit imprimé selon l'une quelconque des revendications 1 à 6.

8. Procédé d'amélioration de la capacité anti-interférence d'une carte de circuit imprimé comportant une antenne de travail (1), **caractérisé en ce que** le procédé comprend :
la fourniture (501) d'une antenne anti-interférence (3) sur la carte de circuit imprimé ; et
le réglage (502) de l'impédance entre une borne d'entrée de signal de l'antenne de travail (1) et une borne de masse commune (2) de la carte de circuit imprimé de façon à ce qu'elle soit supérieure à l'impédance entre une borne d'entrée de signal de l'antenne anti-interférence (3) et la borne de masse commune (2) de la carte de circuit imprimé, l'antenne anti-interférence (3) étant munie d'un circuit de commande de la fréquence de résonance configuré de telle sorte qu'un signal d'interférence au niveau de la borne de masse commune (2) entre dans l'antenne anti-interférence (3) pour être diffusé.

9. Procédé selon la revendication 8, comprenant en outre :
la définition d'une antenne unipolaire comme antenne de travail (1).

10. Procédé selon la revendication 8, comprenant en outre :
le réglage de la borne d'entrée de signal de l'antenne anti-interférence (3) de façon à la connecter à la borne de masse commune (2).
